# EUROPEAN PATENT SPECIFICATION

(11) **EP 3 813 098 B1**
(45) Date of publication and mention of the grant of the patent: **03.12.2025**
(21) Application number: 19205351.0
(22) Date of filing: 25.10.2019
(51) Int. Cl.: H01L 21/48, H05K 7/20, H01L 23/427, H01L 23/367, F28D 15/04, F28D 15/02, F28F 1/24, F28F 1/26, F28F 1/32, F28F 3/04

(54) **VAPOR CHAMBER**
DAMPFKAMMER
CHAMBRE DE VAPEUR

(43) Date of publication of application: 28.04.2021
(73) Proprietor: ABB Schweiz AG, 5400 Baden (CH)
(72) Inventor: Torresin, Daniele, 5400 Baden (CH); Agostini, Bruno, 8006 Zürich (CH); Petrov, Andrey, 8048 Zürich (CH)
(74) Representative: Sykora & König Patentanwälte PartG mbB

(56) References cited:
- EP-A1- 2 677 261
- EP-A1- 3 190 371
- EP-A1- 3 279 597
- CN-A- 1 670 950
- CN-A- 105 845 648
- CN-B- 101 566 331
- US-A1- 2014 311 712
- US-A1- 2019 257 590
- US-B1- 9 980 410

## Description

### Technical Field

The invention relates to vapor chamber. The present invention particularly refers to a vapor chamber for dissipating heat from a heat source, such as from an electronic device, especially from a power semiconductor module having an improved cooling capacity. The present invention further relates to an arrangement of a power semiconductor module and such a vapor chamber, wherein the vapor chamber is configured for cooling the power semiconductor module.

### Background Art

Power semiconductor modules are generally widely known in the art. Power semiconductor modules may comprise a baseplate that may carry an electric circuit comprising one or more power semiconductor devices. For protection of the power semiconductor module, the latter may be encapsulated at least in part by an encapsulation material. The encapsulation may be formed in a transfer molding process. Transfer molding is a manufacturing process where the encapsulation material may be forced into a mold. During this process the encapsulation material may not only cover the electric circuit on the baseplate, but also an edge side of the baseplate.

Vapor chambers are known in the art. Such vapor chambers are used for dissipating energy such as from electronic parts. Additionally to two-dimensional vapor chambers, so-called three-dimensional vapor chambers are known which comprise an evaporator and a condenser being provided in a T-like arrangement.

The current ratings of power electronic devices are continuously increasing while maintaining or even reducing their footprint. This leads to higher heat loss densities which require advanced cooling concepts. In fact, traditional aluminum or copper heat sinks are limited by heat flux densities of 10 W/cm². Recently vapor chamber heat sinks which are state of the art technology used in CPU cooling, have emerged as a valid alternative compared to water cooling for high heat flux densities in the power electronic applications.

US 9,909,448 B2 describes a heat transfer apparatus for a gas turbine engine which includes: a component having a wall structure defining a flow bounding surface; a chamber formed in the component, the chamber including a wick structure, a vapor channel, and a working fluid. It is further described that the component includes an airfoil having opposed pressure and suction sidewalls, a root, a tip, and spaced-apart leading and trailing edges.

US 2018/045063 A1 describes ceramic matrix composite (CMC) airfoils and methods for forming CMC airfoils. In one embodiment, an airfoil is provided that includes opposite pressure and suction sides extending radially along a span and opposite leading and trailing edges extending radially along the span. The leading edge defines a forward end of the airfoil, and the trailing edge defines an aft end of the airfoil. A trailing edge portion is defined adjacent the trailing edge at the aft end, and a pocket is defined in and extends within the trailing edge portion. A heat pipe is received in the pocket. A method for forming an airfoil is provided that includes laying up a CMC material to form an airfoil preform assembly; processing the airfoil preform assembly; defining a pocket in a trailing edge portion of the airfoil; and inserting a heat pipe into the pocket. Such components are uses for gas turbine engines.

US 5,975,841 refers to an apparatus which is a heat pipe with an internal, multiple chamber evaporator for cooling a turbine engine stator vane. The evaporator comprises leading edge, middle, and trailing edge chambers within the stator vane, with the chambers defined by structural support ribs. Each chamber is constructed with a continuous fine pore metal powder wick coating the internal surfaces of the chamber and enclosing the chamber's central vapor space, except the wick at the very trailing edge of the vane is formed by screen embedded in the adjacent powder wick. The evaporator chambers have capillary arteries which extend through the adiabatic section of the heat pipe and terminate in a condenser wick within a heat sink structure exposed to cooler air. A capillary artery also interconnects the wick of the trailing edge chamber to the wick of the middle chamber. Such an arrangement is used for cooling turbine engine stators.

However, the above cited references do not give any hint for providing an improvement with regard to improving cooling of power semiconductor modules or other heat sources.

US 2019/257590 A1 describes an air-cooled plate-fin phase-change radiator with compo-site capillary grooves which includes a heat exchanger box and base plates. Inside such a base plate, there is an inner cavity holding the working medium. The heat exchanger box is composed of a cooling medium channel. Radiating fins and phase-change channels are set alternately inside the cooling medium channel.

US9,980,410 B1 describes a heat dissipating device, including one or more heat pipes in thermal communication with a baseplate, where one or more heat pipes has one or more internal cavities.

CN 1 670 950 A describes an externally diversion integrated heat pipe radiator. It includes a closed vacuum box body for absorbing heat, and the vacuum box body is filled with a liquid working medium (not shown in the figure) that vaporizes when heated and condenses. Three parallel vacuum heat dissipation plates are erected on the surface of the vacuum box body. Fins for expanding the heat dissipation area are welded between the vacuum heat dissipation plates.

### Summary of invention

It is therefore an object of the invention to provide a solution for overcoming at least one disadvantage of the prior art at least in part. It is especially an object of the present invention to provide an improved cooling device, in particular for a power semiconductor module having an improved producibility and a high quality.

It is therefore an object of the invention to provide an air cooler such as for a power semiconductor module which has improved cooling performance compared to state of the art heat sinks. It is further an object of the present invention to provide an arrangement of a power semiconductor module and a cooler which shows improved cooling behaviour.

These objects are solved at least in part by a vapor chamber having the features of independent claim 1. These objects are further solved at least in part by an arrangement having the features of independent claim 9 and by a use having the features of independent claim 10. Advantageous embodiments are given in the dependent claims, in the further description as well as in the figures, wherein the described embodiments can, alone or in any combination of the respective embodiments, provide a feature of the present invention unless not clearly excluded.

Described is a vapor chamber for cooling a heat source, wherein the vapor chamber comprises an evaporator proceeding in a first plane, and wherein the vapor chamber comprises at least a first condenser and a second condenser, wherein the first and second condenser are internally coupled to the evaporator, wherein the first condenser proceeds in a second plane, and the second condenser proceeds in a third plane, wherein the second plane and the third plane are arranged in an angle to the first plane, wherein at least one air fin is provided, wherein the at least one an air fin proceeds in a fourth plane, and wherein the first condenser and the second condenser are internally coupled to the air fin, and wherein the evaporator, the first condenser, the second condenser and the air fin form a common internal volume.

Such a vapor chamber provides a cooler for a heat source such as for a power semiconductor module which shows improved cooling behaviour.

Described is thus a vapor chamber for cooling a heat source. The heat source is not strictly limited but it may preferably be an electronic device, such as a power semiconductor module. The vapor chamber thus serves as a cooler for a heat source, such as for a power semiconductor module, which can be mounted, for example, to a baseplate of the power semiconductor module in order to cool the power semiconductor module.

Generally, a vapor chamber is an advantageous alternative to coolers using cooling liquids.

A vapor chamber is a heat spreader with the same primary components as heat pipes: a hermetically sealed hollow vessel, a working fluid, and a closed-loop recirculation system. In addition, a series of posts may be used in a vapor chamber, to prevent any mechanical deformations when the internal fluid pressure is below or above the atmospheric pressure.

The vapor chamber utilizes the advantages of the latent heat needed for the evaporation and condensation processes. The heat input to the evaporator vaporizes the working liquid provided inside the recirculation system, which flows to the condenser surfaces. After the vapor condenses on the condenser surfaces, capillary forces in the wick return the condensate to the evaporator.

Vapor chambers are emerging as the alternative solutions to water cooling for high heat flux densities in power electronic. In order to function as an air heat sink and according to known vapor chambers, metallic full bodied lamellas are bonded to condenser side of the vapor chamber increasing the heat transfer area. The heat exchange from the lamellas to the air is the limiting factor of vapor chamber based heat sink coolers because standard type of air fins (full bodied lamellas) do not provide high heat transfer coefficient (turbulence) for the air side and also are subjected to the physical limitation due to the fin efficiency.

With regard to the present invention, it is provided that the vapor chamber comprises a specific evaporator-condenser-air fin-structure which is superior compared to prior art solutions.

With this regard, the vapor chamber comprises an evaporator proceeding in a first plane, and comprises at least a first condenser and a second condenser. Therefore, an evaporator is provided and at least two condensers. With this regard, there may be two or more than two condensers without leaving the scope of the present invention.

In order to achieve a hermetically sealed hollow vessel, comprising a working fluid, and a closed-loop capillary recirculation system, it is provided that the first and second condensers are internally coupled to the evaporator. In other words, the internal volume of the evaporator and the condensers is coupled to each other, thus forming a common inner volume.

With regard to the geometrical arrangement, it is provided that the first condenser proceeds in a second plane, and the second condenser proceeds in a third plane, wherein the second plane and the third plane are arranged in an angle to the first plane. In other words, it is provided that the second plane and the third plane are not parallel to the first plane and thus, the evaporator on the one side and both of the first condenser and the second condenser on the other side not arranged parallel to each other.

The vapor chamber is thus a so-called 3D-vapor chamber. With this regard, the vapor chamber comprises the evaporator serving for evaporating the working liquid, such as water, and thus for coming in contact to a component to be cooled, such as to a baseplate of a power semiconductor module. Further, the vapor chamber comprises at least two condensers in which the working liquid is again condensed and may thus dissipate energy, or heat, respectively, away from the vapor chamber.

Like indicated above, it is further provided that at least one air fin is provided, wherein the at least one an air fin proceeds in a fourth plane, and wherein the evaporator, the first condenser, the second condenser and the air fin form a common internal volume. An air fin is generally known per se and allows increasing the air heat transfer coefficient. In other words, provided air fins may enhance the cooling capacity of the vapor chamber. According to the present invention, it is with this regard provided that the one or more air fins together with the evaporator and the condensers form a common inner volume and is thus coupled to the internal structure of the evaporator and the condensers. Each air fin may be located between two condensers and may be internally coupled thereto.

Such an arrangement allows a particularly good cooling capacity of the vapor chamber.

According to a vapor chamber as described above, a solution is provided by combining a vapor chamber evaporator with at least two condensers extending in an angle to the evaporator, such as perpendicularly. In this way the condenser and the internal fluid heat exchange areas are increased. The condensers are then connected with one or more fins having a hollow structure that allows an internal fluid circulation trough the one or more air fins and between the condensers at the same time.

Such a vapor chamber thus allows a very high cooling capacity of the vapor chamber anyhow not requiring a liquid cooled heat exchanger.

Given the above, a vapor chamber as described provides an advanced cooler for heat sources such as power semiconductor modules and in particular for power electronics devices, such as IGBTs as non-limiting examples, utilizing air as final cooling media. The vapor chamber as described allows to stretch the applicability of air cooling toward high heat flux densities, such as in a non-limiting area of > 50 W/cm². Such cooling capacities according to the prior art require pumped water cooling which, however, can be avoided according to the present invention.

The vapor chamber as described allows reducing the air side thermal resistance by the one or more hollow air fins and thus by creating a tridimensional internal fluid path. The vapor flows in the hollow paths and condenses on the colder surfaces of the condensers as well as of the one or more air fins. Then, the condensate returns to evaporator by using capillary pumping provided by the porous structure bonded in the internal walls of the condenser.

It may be preferred that the at least one air fin at least in part has a cross section of an air foil. According to this embodiment, especially the outer structure of the one or more air fins is improved, especially with regard to a rectangular or round cross section, for example. With this regard, it could be found that air fins having an external airfoil shape significantly maximize the ratio of air heat transfer coefficient over pressure drop. In fact, having the fluid condensing internally the airfoils allows to have a uniform temperature yielding a fin efficiency of 100%. Therefore, the cooling performance of a vapor chamber may be significantly improved according to this embodiment.

The cross section of an air foil may according to this embodiment be especially preferred provided in case an air foil is visible when looking from the first condenser to the second condenser.

It may further be preferred that at least one of the first condenser, the second condenser and the air fin are provided with an internal capillary structure. Providing an internal capillary structure, and thus providing an internal capillary structure in the inner volume of these components and particularly at the inner wall of these compounds, may especially help condensing the vapor of the working liquid during a cooling process and guide condensed water back to the evaporator. Thus, such a structure may significantly enhance the working capability and thus the cooling capability of the vapor chamber. Such a capillary structure may provide at the same time capillary pressure to ensure the fluid circulation and to enhance the heat transfer.

With regard to the capillary structure, it might be provided that the capillary structure of at least one of the first condenser, the second condenser and the air fin is formed as a three-dimensional mesh. This embodiment allows the formation of a capillary structure which may effectively transport and guide the condensed working liquid into the evaporator and may further effectively assist in working liquid to be condensed. Thus, again, this embodiment helps the vapor chamber to work in a very efficient manner.

A three-dimensional mesh in the sense of the present invention may be a structure in which a strand is not only interwoven, or intermeshed, respectively, in a two-dimensional extension, but which structure is respectively intermeshed in a three-dimensional manner.

It should further be noted that a mesh according to the present invention is not strictly a structure which is formed of a strand being intermeshed, but such a structure may also be formed, for example, by additive manufacturing resulting in the same or a comparable structure.

It may further be provided that the capillary structure of at least one of the first condenser, the second condenser and the air fin is formed from a material selected from the non-limiting group consisting of stainless steel copper and aluminum. It was found that these materials show synergistic effects in the properties as required. In detail such materials on the one hand allow an effective working behaviour of the vapor chamber and on the other hand may be processed in a very defined manner so that the provided structures in turn may have a very defined size and geometry. For example, such materials may be processed by additive manufacturing like described in greater detail below.

It may be especially preferred that all of the first condenser, the second condenser and the air fin are provided with an internal capillary structure like described above, which may in an especially preferred manner be formed by additive manufacturing. This may allow that all capillary structures may be connected to each other in a functional effective and continuous three-dimensional manner. A problem of breaking up the continuity of the vapor chamber capillary structure can be circumvented effectively. Thus, again, the cooling capacity of the vapor chamber may be preferred especially effectively.

It may further be preferred that a plurality of air fins is provided being arranged in at least two rows, the at least two rows being arranged one behind the other in an air flowing direction of the vapor chamber, and wherein at least two rows are positioned relative to another in a staggered arrangement.

According to this arrangement, the heat transfer of the air fins may be especially effective, so that the cooling capacity of the vapor chamber may be especially high.

It may further be preferred that at least one condenser is formed in a straight arrangement. A straight arrangement according to this embodiment shall particularly mean that the condenser, such as the cross section of the condenser, proceed in a straight line and may for example be formed plate-like. The straight line or the plate-like arrangement may be visible when looking from the first condenser to the second condenser or vice versa, for example. This arrangement allows stacking a plurality of condensers on a comparably small volume. Thus, small vapor chambers may be provided with a great cooling capacity allowing significant applicability.

Alternatively, it may be preferred that at least one condenser is formed in at least one of a waved or dendritic arrangement, such as a tree-shaped arrangement. Again, the waved or dendritic arrangement, or cross section, respectively, may be visible when looking from the first condenser to the second condenser, or vice versa, for example. This arrangement allows providing a very adaptive cooling capacity at different positions, so that the applicability may as well be enhanced. Further, potential hot spots may be cooled in a very efficient manner which allows an especially effective cooling behaviour.

Further, such shapes will intensify the heat dissipation on the air side by increasing the flow turbulence and enhancing cooling capacity.

This embodiment may be especially preferred when using additive manufacturing for producing the vapor chamber, for example. This embodiment, such as by using additive manufacturing, allows for customization of the design for a specific application, e.g. the position of the condensers and of the hollow fins can be adjusted for each particular IGBT design to enhance the heat transfer in areas with local hot spots. Thus, an electronic device such as a power semiconductor module being provided with a vapor chamber especially according to thus embodiment may work especially reliable.

It may further be preferred that that the first plane is arranged parallel to the fourth plane and that the second plane is arranged parallel to the third plane, and that the first plane proceeds in a right angle and thus perpendicular to the second plane. Thus, in other words, the evaporator and the air fins on the one side and the condensers on the other side may be connected to each other in a perpendicular arrangement.

According to this embodiment, thus a kind of rectangular structure may be formed by respectively positioning the evaporator, the condensers as well as the one or more air fins. Thus, the evaporator and the air fins may be arranged as horizontal parts whereas the condenser may be arranged as vertical parts. It was found that this embodiment allows a very effective working behaviour of the vapor chamber. This may be due to the fact, for example, air fins which serve for externally cooling the vapor chamber and thus for improving working fluid in the vapor chamber to be condensed, may be formed especially adaptive and may further have a large contact area to the first part. Thus, cooling of the first part and thus condensing of working fluid in the first part is enhanced.

Apart from that, a large amount of condensers and air fins may be realized in a small volume, thus further enhancing cooling capacity.

With regard to further advantages and technical features of the vapor chamber, it is referred to the arrangement, the use, the figures and the further description.

The present invention further relates to an arrangement of a power semiconductor module and a cooler, wherein the cooler comprises a vapor chamber like described in the further description.

The power semiconductor module may generally be formed as it is known in the art. For example, a baseplate may be provided with an electric circuit comprising power semiconductor devices and may be protected by a mold compound, for example. Further, the baseplate may be in contact to a cooler in order to dissipate heat from the baseplate and thus from the electric circuit.

The cooler comprises a vapor chamber like descried. In particular, the evaporator of the baseplate is in close contact to the baseplate so that heat of the baseplate is dissipated by the vapor chamber.

Due to the fact that the vapor chamber is arranged like described, significant advantages over the solutions of the prior art may appear.

With this regard, it may be especially provided that a high cooling capacity may be reached, further allowing a high level of adaptivity. Further, the cooler of this arrangement is easy to form.

With regard to further advantages and technical features of the arrangement, it is referred to the vapor chamber, the use, the figures and the further description.

The present invention further relates to a use of a step of additive manufacturing for forming at least one of an air fin, an evaporator and a condenser for a vapor chamber like described in the further description.

The specific process of additive manufacturing, also called 3D-printing, may be used according to the required needs. For example, selective laser sintering may be used. Using additive manufacturing for forming at least one of an evaporator, a condenser and an air fin may overcome the difficulty of manufacturing and joining complex structures, which brings the required geometrical flexibility and allows to customize the cooler for a particular device design. Thus, the different cross sections particularly of the air fins or condensers, such as dendritic geometries, may be achieved in an especially defined and reliable manner.

Further, next to providing the cross section of the air fins or condensers or the evaporator, also, the capillary structures, such as the three-dimensional mesh, may be provided in a very reliable and defined manner. Thus, the condensed working fluid can effectively be spread in the condensers as well as in the air fins and may effectively be guided to the evaporator, allowing a very effective working behaviour of the formed vapor chamber. As a result, additive manufacturing may be an advantageous measure for forming the vapor chamber in order to reach the advantages as described above. With this regard, the vapor chamber may be at least in part, for example completely be formed from stainless steel, aluminum or copper, for example.

With regard to further advantages and technical features of the use, it is referred to the arrangement, the vapor chamber, the figures and the further description.

### Brief description of drawings

These and other aspects of the invention will be apparent from and elucidated with reference to the embodiments described hereinafter. Individual features disclosed in the embodiments can constitute alone or in combination an aspect of the present invention. Features of the different embodiments can be carried over from one embodiment to another embodiment.

In the drawings:
Fig. 1 shows a vapor chamber according to an embodiment of the present invention;
Fig. 2 shows a corner section cut out of the vapor chamber according to figure 1;
Fig. 3 shows a front section cut of a vapor chamber according to figure 1;
Fig. 4 shows a cross section through air fins looking on a condenser of a vapor chamber according to figure 1;
Fig. 5 shows an embodiment of a condenser;
Fig. 6 shows a further embodiment of a condenser;
Fig. 7 shows a further embodiment of a condenser;
Fig. 8 shows a further embodiment of a condenser; and
Fig. 9 shows a diagram relating to the thermal resistance at different heat loads.

### Description of embodiments

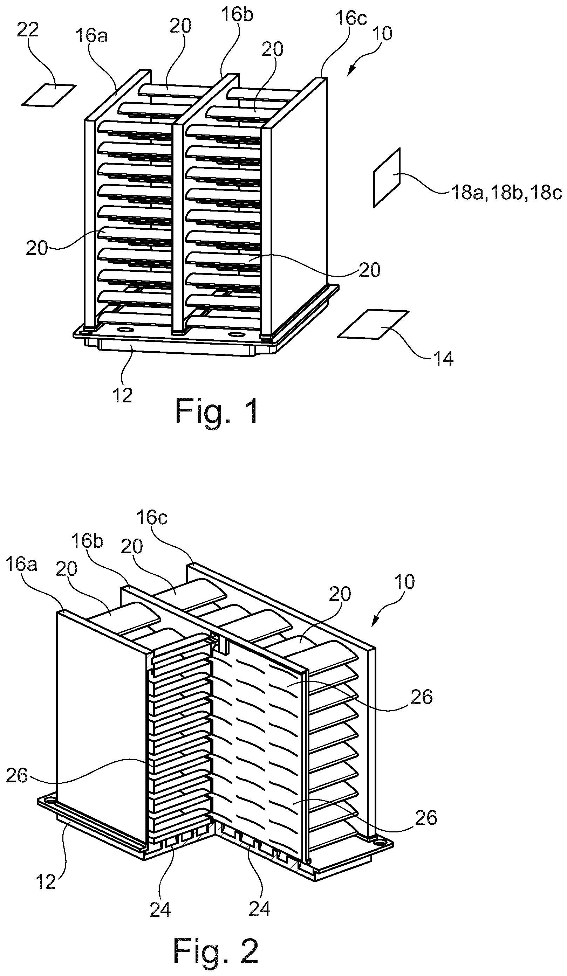

Fig. 1 shows an embodiment of a vapor chamber 10 for cooling a heat source such as for cooling a power semiconductor module, wherein the heat source is not shown as such. The vapor chamber 10 may thus be arranged in thermal contact with the heat source such as with a part of a power semiconductor module, such as with a baseplate, in order to cool the latter.

The vapor chamber 10 comprises an evaporator 12 proceeding in a first plane 14. The first plane 14 thus defines the orientation of the evaporator 12 which generally may have a plate-like form. The vapor chamber 10 according to figure 1 further comprises three condensers 16, i.e. condensers 16ₐ, 16_{b} and 16_{c} which each are internally coupled to the evaporator 12. The condensers 16ₐ, 16_{b} and 16_{c} proceed in respective planes 18ₐ, 18_{b} and 18_{c}, wherein the planes 18ₐ, 18_{b} and 18_{c} are arranged perpendicular to the first plane 14 and are thus arranged parallel to each other. The planes 18ₐ, 18_{b} and 18_{c} are identical and comprise the second plane and the third plane. Figure 1 further sows that a plurality of air fins 20 is provided, wherein the air fins 20 are arranged parallel to each other and in particular in a fourth plane 22.

With regard to the evaporator 12, the condensers 16ₐ, 16_{b} and 16_{c} and the air fins 20, it is provided that these parts form a common internal volume. In other words, these parts are internally coupled to each other.

Figure 1 thus shows an external view of a 3-dimensional vapor chamber 10 in which the evaporator 12 with its baseplate is shown at the bottom, three condensers 16ₐ, 16_{b} and 16_{c} are shown vertically and the numerous condenser-airfoils as air fins 20 are shown horizontally in between. The number of airfoils, or air fins 20, respectively, is determined to achieve the prescribed fluid temperature inside the vapor chamber 10 and may generally be chosen according to the desired needs.

Figure 2 shows a corner section cut of a vapor chamber 10. In figure 2, again, the evaporator 12, the condensers 16ₐ, 16_{b} and 16_{c} and the air fins 20 are shown.

In more detail, according to figure 2, the internal structure is visible, showing evaporator wicks 24 which may be formed as a porous coating. Next to the evaporator wicks 24, condenser wicks 26 are shown. Both of the evaporator wicks 24 and the condenser wicks 26 may comprise capillary structures. The condenser wick 26 is found only on the vertical areas and potentially in the air fins 20 and is made of a very fine diameter, such as 50 micrometer, metallic mesh. It may be preferred to create the said wicks 24, 26 inside the inner volume using metal additive manufacturing technology (AM technology). By doing so, the potentially difficult and unreliable process of joining the vertical and horizontal parts of the above described capillary structure will be avoided. In this embodiment, the air fins 20 act at the same time as air turbulators and condensing sections.

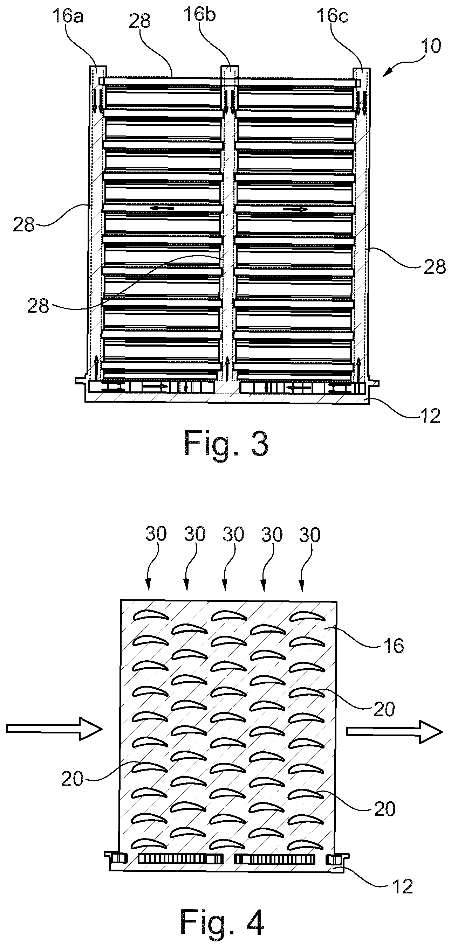

Figure 3 shows a front section cut of a vapor chamber 10 with the internal vapor and liquid circulation. In detail, the evaporator 12 as well as the condensers 16ₐ, 16_{b}, 16_{c} are shown with their internal capillary structure.

The lines 28 show the positions of the condenser wicks 26. The purpose of the condenser wick 26 wick is to provide at the same time capillary pressure to ensure the fluid circulation and to enhance the heat transfer. For this reason, it might be preferred that the shown structure comprises a 3-dimensional capillary structure made, for example, of 100 microns large elements maximum. It may be formed by sintering of copper powder. Preferably, however, it may be formed by metallic additive manufacturing, which will allow to have it inside the hollow air fins 20 as well.

The arrows shown in the internal structure additionally indicate that the working fluid is evaporated, condensed in the air fins 20 and condensers 16ₐ, 16_{b}, 16_{c} and guided back to the evaporator 12 in liquid form.

In figure 4, a condenser 16 is shown and in a cross section the air fins 20, wherein the arrows indicate the air flow through the air fins 20 and thus through the vapor chamber 10. In detail, the side section cut of the vapor chamber 10 shows the distinctive shape of the hollow air fins 20, which have a cross section of airfoils. It was found that these structures can improve the external heat transfer coefficient with air and at the same time reduce the pressure drop. Actually the ratio of heat transfer over the pressure drop can be increased by up to 50%. The hollow airfoil structure that houses a condenser wick 26 structure for condensation, allows the air fins 20 to have a uniform temperature, thus yielding a fin efficiency of 100%, compared to 50% in traditional heat sinks with metallic full bodied straight fin.

It can further be seen, that a plurality of air fins 20 is provided being arranged in a plurality of rows 30, the rows 30 being arranged one behind the other in the air flowing direction of the vapor chamber 10, and that the rows 30 are positioned relative to another in a staggered arrangement.

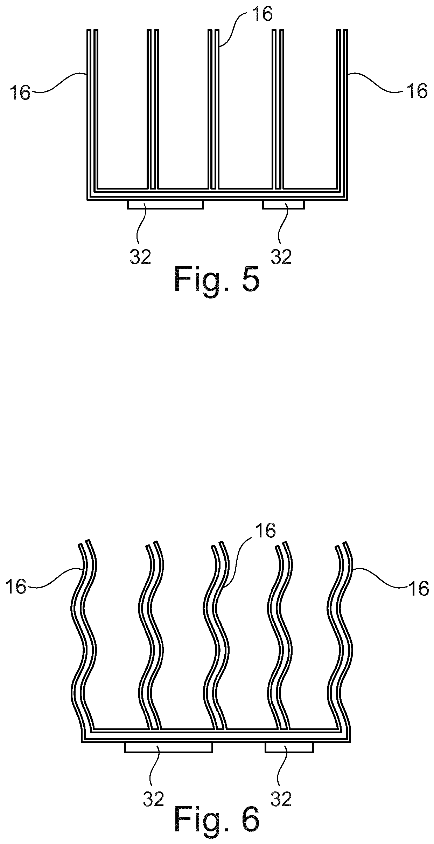

Figures 5 to 8 show different embodiments of the condensers 16, which may be realized in an especially defined and reliable manner by using additive manufacturing in order to further optimize the heat exchanger design.

With this regard, figure 5 shows an arrangement in which the condenser 16, such as the second condenser 16b or all condensers 16 present, is formed in a straight arrangement.

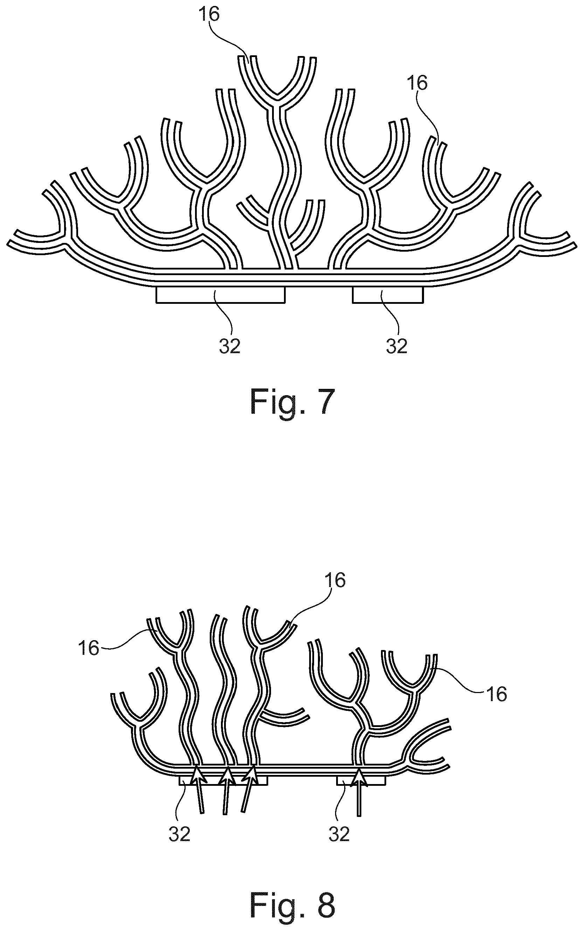

Further, figures 6 to 8 show arrangements in which the condenser 16, such as the second condenser 16b or all condensers 16 present, is formed in at least one of a waved or dendritic arrangement. Under these figures, figure 6 shows a wave form of the condenser 16 and figures 7 and 8 show different embodiments of tree-shaped forms.

Figures 5 to 8 show a side view onto a condenser and thus for example from one condenser 16 to a further condenser 16.

For instance, forming such as printing the condensers 16 in wave shape or further forms like described will intensify the heat dissipation on the air side by increasing the flow turbulence. Additive manufacturing also enables other solutions to be tested, such as tree-shaped heat pipes, like discussed. In addition, additive manufacturing allows for customization of the design for a specific application: the position of the condensers 16 can be adjusted for each particular design of power semiconductor devices, such as of IGBTs to enhance the heat transfer in areas with local hot spots 32.

In more detail, the structures as shown allow that an especially efficient cooling may be realized in regions in which thermal hot spots 32 arise. This may be due to the fact that the density of condensers 16 and air fins 20 may be increased in these regions.

This may be seen at a comparison of figures 7 and 8, respectively. With this regard, figure 7 already shows an improved arrangement of the condenser 16 in which a tree-like structure is provided showing the advantages as described above. However, regarding figure 8, a further optimization is provided in that the condenser 16 with its air fins 20 is especially present in areas of thermal hot spots 32 like indicated by the arrows. Thus, the cooling effectivity is further enhanced.

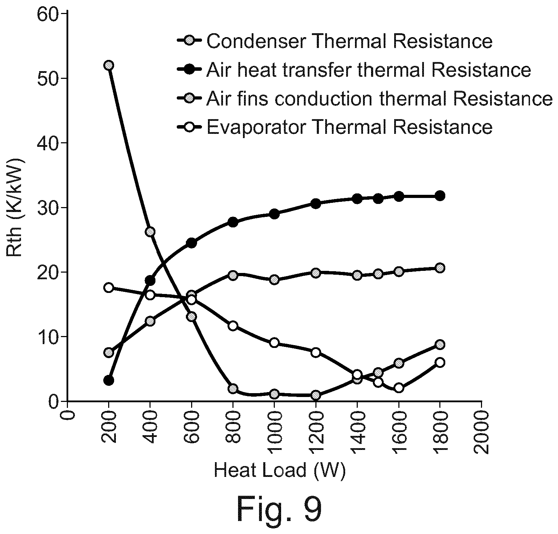

Figure 9 shows a diagram showing that the dominating thermal resistances (Rth, shown at the y-axis) are due to the air heat transfer and to the heat conduction through the air fins 20. At high heat loads (e.g. > 1 kW, shown at the x-axis) their values can be two to three times higher than the vapor chamber condenser and evaporator thermal resistances.

Therefore the present invention gives a solution to reduce the air side thermal resistance of advanced vapor chambers 10 for heat sinks, for example.

There can be two condensers 16, or even three or more than three, and the shape and arrangement of the air fins 20 as well as of the condensers 16 may be adapted to the desired needs. This invention is expected to work in any orientation (against gravity), thanks to the capillary pumping provided by the wick.

### Reference signs list

- 10: vapor chamber
- 12: evaporator
- 14: plane
- 16: condenser
- 18: plane
- 20: air fin
- 22: plane
- 24: evaporator wick
- 26: condenser wick
- 28: line
- 30: row
- 32: thermal hot spot

## Claims

1. A vapor chamber (10) for cooling a heat source, wherein the vapor chamber (10) comprises:
an evaporator (12) for evaporating a working liquid;
at least a first condenser (16ₐ) and a second condenser (16_{b}), in which the working liquid is condensed;
at least one air fin (20), being hollow;
wherein the evaporator (12) proceeds in a first plane (14),
wherein the first condenser (16ₐ) proceeds in a second plane, and the second condenser (16_{b}) proceeds in a third plane, wherein the second plane and the third plane are arranged in an angle to the first plane (14),
wherein the at least one an air fin (20) proceeds in a fourth plane,
wherein the first condenser (16ₐ) and the second condenser (16_{b}) are internally coupled to the evaporator (12) and are internally coupled to the air fin (20), and the evaporator (12), the first condenser (16ₐ), the second condenser (16_{b}) and the at least one air fin (20) form a common internal volume, in order to achieve a hermetically sealed hollow vessel comprising the working liquid;
wherein the first condenser (16ₐ) and the second condenser (16_{b}) are connected with the at least one an air fin (20) having a hollow structure that allows an internal fluid circulation through the at least one air fin (20) and between the first condenser (16ₐ) and the second condenser (16_{b}).

2. The vapor chamber (10) according to claim 1, wherein the at least one air fin (20) at least in part has a cross section of an air foil.

3. The vapor chamber (10) according to claim 1 or 2, wherein at least one of the first condenser (16ₐ), the second condenser (16_{b}) and the air (20) fin is provided with an internal capillary structure.

4. The vapor chamber (10) according to claim 3, wherein the capillary structure of at least one of the first condenser (16ₐ), the second condenser (16_{b}) and the at least one air fin (20) is formed as a three-dimensional mesh.

5. The vapor chamber (10) according to any of claims 1 to 4, wherein a plurality of air fins (20) is provided being arranged in at least two rows (30), the at least two rows (30) being arranged one behind the other in an air flowing direction of the vapor chamber (10), and wherein at least two rows (30) are positioned relative to another in a staggered arrangement.

6. The vapor chamber (10) according to any of claims 1 to 5, wherein at least one condenser (16) is formed in a straight arrangement.

7. The vapor chamber (10) according to any of claims 1 to 5, wherein at least one condenser (16) is formed in at least one of a waved or dendritic arrangement.

8. The vapor chamber to any of claims 1 to 7, wherein the first plane (14) is arranged parallel to the fourth plane and in that the second plane is arranged parallel to the third plane, and in that the first plane (14) proceeds in a right angle to the second plane.

9. An arrangement of a power semiconductor module and a cooler, wherein the cooler comprises a vapor chamber (10) according to any of claims 1 to 8.

10. A use of a step of additive manufacturing for forming at least one of an evaporator (12), a condenser (16) and an air fin (20) for a vapor chamber (10) according to any of claims 1 to 8.

## Patentansprüche

1. Dampfkammer (10) zum Kühlen einer Wärmequelle, wobei die Dampfkammer (10) umfasst:
einen Verdampfer (12) zum Verdampfen einer Arbeitsflüssigkeit;
mindestens einen ersten Verflüssiger (16ₐ) und einen zweiten Verflüssiger (16_{b}), in denen die Arbeitsflüssigkeit verflüssigt wird;
mindestens eine Luftfinne (20), die hohl ist;
wobei sich der Verdampfer (12) in einer ersten Ebene (14) erstreckt,
wobei sich der erste Verflüssiger (16ₐ) in einer zweiten Ebene erstreckt, und wobei sich der zweite Verflüssiger (16_{b}) in einer dritten Ebene erstreckt, wobei die zweite Ebene und die dritte Ebene in einem Winkel zu der ersten Ebene (14) angeordnet sind,
wobei sich die mindestens eine Luftfinne (20) in einer vierten Ebene erstreckt,
wobei der erste Verflüssiger (16ₐ) und der zweite Verflüssiger (16_{b}) intern mit dem Verdampfer (12) gekoppelt sind und intern mit der Luftfinne (20) gekoppelt sind, und wobei der Verdampfer 12, der erste Verflüssiger (16ₐ), der zweite Verflüssiger (16_{b}) und die mindestens eine Luftfinne (20) ein gemeinsames internes Volumen bilden, um einen hermetisch abgedichteten hohlen Behälter zu erreichen, der die Arbeitsflüssigkeit umfasst;
wobei der erste Verflüssiger (16ₐ) und der zweite Verflüssiger (16_{b}) mit der mindestens einen Luftfinne (20) verbunden sind, die eine hohle Struktur aufweist, die eine interne Fluidzirkulation durch die mindestens eine Luftfinne (20) und zwischen dem ersten Verflüssiger (16ₐ) und dem zweiten Verflüssiger (16_{b}) erlaubt.

2. Dampfkammer (10) nach Anspruch 1, wobei die mindestens eine Luftfinne (20) mindestens teilweise einen Querschnitt einer Tragfläche aufweist.

3. Dampfkammer (10) nach Anspruch 1 oder 2, wobei mindestens einer des ersten Verflüssigers (16ₐ), des zweiten Verflüssigers (16_{b}) und der Luftfinne (20) mit einer internen Kapillarstruktur versehen ist.

4. Dampfkammer (10) nach Anspruch 3, wobei die Kapillarstruktur von mindestens einem des ersten Verflüssigers (16ₐ), des zweiten Verflüssigers (16_{b}) und der mindestens einen Luftfinne (20) als ein dreidimensionales Gitter gebildet ist.

5. Dampfkammer (10) nach einem der Ansprüche 1 bis 4, wobei eine Vielzahl von Luftfinnen (20) bereitgestellt wird, die in mindestens zwei Reihen (30) angeordnet sind, wobei die mindestens zwei Reihen (30) eine hinter der anderen in einer Luftstromrichtung der Dampfkammer (10) angeordnet sind, und wobei die mindestens zwei Reihen (30) in einer gestaffelten Anordnung relativ zueinander positioniert sind.

6. Dampfkammer (10) nach einem der Ansprüche 1 bis 5, wobei mindestens ein Verflüssiger (16) in einer geraden Anordnung gebildet ist.

7. Dampfkammer (10) nach einem der Ansprüche 1 bis 5, wobei mindestens ein Verflüssiger (16) in mindestens einer von einer gewellten oder dendritischen Anordnung gebildet ist.

8. Dampfkammer nach einem der Ansprüche 1 bis 7 wobei die erste Ebene (14) parallel zur vierten Ebene angeordnet ist und wobei die zweite Ebene parallel zur dritten Ebene angeordnet ist und wobei sich die erste Ebene (14) in einem rechten Winkel zur zweiten Ebene erstreckt.

9. Anordnung eines Leistungshalbleitermoduls und eines Kühlers, wobei der Kühler eine Dampfkammer (10) nach einem der Ansprüche 1 bis 8 umfasst.

10. Verwendung eines Schritts eines additiven Fertigens zum Bilden mindestens eines von einem Verdampfer (12), einem Verflüssiger (16) und einer Luftfinne (20) für eine Dampfkammer (10) nach einem der Ansprüche 1 bis 8.

## Revendications

1. Chambre à vapeur (10) pour refroidir une source de chaleur, la chambre à vapeur (10) comprenant :
un évaporateur (12) pour évaporer un liquide de travail ;
au moins un premier condenseur (16ₐ) et un deuxième condenseur (16_{b}), dans lesquels le liquide de travail est condensé ;
au moins une ailette d'air (20), étant creuse ;
l'évaporateur (12) s'étendant dans un premier plan (14), le premier condenseur (16ₐ) s'étendant dans un deuxième plan, et le deuxième condenseur (16_{b}) s'étendant dans un troisième plan, le deuxième plan et le troisième plan étant disposés dans un angle par rapport au premier plan (14),
l'au moins une ailette d'air (20) s'étendant dans un quatrième plan,
le premier condenseur (16ₐ) et le deuxième condenseur (16_{b}) étant couplés intérieurement à l'évaporateur (12) et étant couplés intérieurement à l'ailette d'air (20), et l'évaporateur (12), le premier condenseur (16ₐ), le deuxième condenseur (16_{b}) et l'au moins une ailette d'air (20) formant un volume intérieur commun, afin d'obtenir un récipient creux hermétiquement fermé contenant le liquide de travail ;
le premier condenseur (16ₐ) et le deuxième condenseur (16_{b}) étant reliés à l'au moins une ailette d'air (20) ayant une structure creuse qui permet une circulation interne de fluide à travers l'au moins une ailette d'air (20) et entre le premier condenseur (16ₐ) et le deuxième condenseur (16_{b}).

2. Chambre à vapeur (10) selon la revendication 1, dans laquelle l'au moins une ailette d'air (20) a, au moins en partie, une section transversale ayant un profil aérodynamique.

3. Chambre à vapeur (10) selon la revendication 1 ou la revendication 2, dans laquelle au moins l'un du premier condenseur (16ₐ), du deuxième condenseur (16_{b}) et de l'ailette d'air (20) est muni d'une structure capillaire interne.

4. Chambre à vapeur (10) selon la revendication 3, dans laquelle la structure capillaire d'au moins l'un du premier condenseur (16ₐ), du deuxième condenseur (16_{b}) et de l'au moins une ailette d'air (20) est formée sous la forme d'un maillage tridimensionnel.

5. Chambre à vapeur (10) selon l'une quelconque des revendications 1 à 4, dans laquelle une pluralité d'ailettes d'air (20) sont pourvues et agencées selon au moins deux rangées (30), les au moins deux rangées (30) étant agencées l'une derrière l'autre dans une direction d'écoulement d'air de la chambre à vapeur (10), et dans laquelle au moins deux rangées (30) sont positionnées l'une par rapport à l'autre suivant un agencement décalé.

6. Chambre à vapeur (10) selon l'une quelconque des revendications 1 à 5, dans laquelle au moins un condenseur (16) est formé dans un agencement droit.

7. Chambre à vapeur (10) selon l'une quelconque des revendications 1 à 5, dans laquelle au moins un condenseur (16) est formé suivant au moins un agencement parmi une agencement ondulé ou un agencement dendritique.

8. Chambre à vapeur selon l'une quelconque des revendications 1 à 7, dans laquelle le premier plan (14) est agencé parallèlement au quatrième plan et étant **caractérisé en ce que** le deuxième plan est agencé parallèlement au troisième plan, et **en ce que** le premier plan (14) s'étend à angle droit par rapport au deuxième plan.

9. Agencement d'un module semi-conducteur de puissance et d'un refroidisseur, dans lequel le refroidisseur comprend une chambre à vapeur (10) selon l'une quelconque des revendications 1 à 8.

10. Utilisation d'une étape de fabrication additionnelle pour former au moins l'un d'un évaporateur (12), d'un condenseur (16) et d'une ailette d'air (20) pour une chambre à vapeur (10) selon l'une quelconque des revendications 1 à 8.
